(19) Europäisches Patentamt
European Patent Office
Office européen des brevets

(11) **EP 4 389 692 A1**

(12) **EUROPEAN PATENT APPLICATION**

(43) Date of publication:
**26.06.2024 Bulletin 2024/26**

(21) Application number: **22214665.6**

(22) Date of filing: **19.12.2022**

(51) International Patent Classification (IPC):
**C01B 3/00** (2006.01)

(52) Cooperative Patent Classification (CPC):
**C01B 3/001**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Epinovatech AB**
**223 63 Lund (SE)**

(72) Inventor: **OLSSON, Martin Andreas**
**223 63 Lund (SE)**

(74) Representative: **Zacco Sweden AB**
**P.O. Box 5581**
**Löjtnantsgatan 21**
**114 85 Stockholm (SE)**

(54) **A DEVICE AND A METHOD FOR HYDROGEN STORAGE**

(57) A device (1) for hydrogen storage, comprising:
a semiconductor substrate (2);
at least one pillar (10) being arranged on the semiconductor substrate (2), the at least one pillar (10) comprising a core (12) and a shell (14), the core (12) of the pillar (10) comprising semiconductor material and the shell (14) of the pillar (10) enclosing the core (12) of the pillar (10), the shell (14) comprising:

$Mg_3N_2$;

and/or
a plurality of GaN particles (16).

Fig. 1A

EP 4 389 692 A1

**Description**

TECHNICAL FIELD

The present inventive concept relates, in general, to a device and a method for hydrogen storage.

BACKGROUND

Hydrogen is considered to be a clean and sustainable energy source, and storing hydrogen under ambient conditions is a focus area for research and development. For example, a challenge to the widespread commercialization of fuel cell electric vehicles (FCEVs) and other hydrogen fuel cell applications is how to store the hydrogen in a compact, reliable and cost-effective way.

One alternative for storing hydrogen includes large-volume systems that store hydrogen in gaseous form. Storage of gaseous hydrogen requires high-pressure tanks. Compressed hydrogen may for example be kept at a tank pressure of around 350-700 bar. Disadvantages of storing compressed gaseous hydrogen include a high energy penalty for compression, which can consume some of the total internal energy of the hydrogen. In addition, expensive carbon fiber wound cylinders may be needed to withstand pressure in the higher ranges. Other options for hydrogen storage may include liquefied hydrogen. The boiling point of hydrogen is -252.9°C and to liquefy hydrogen, the temperature needs to be reduced to cryogenic temperatures. The liquefaction process may consume a few tenths of the total internal energy of the hydrogen. It may further be difficult to prevent loss of hydrogen through boil-off when storing it as a liquid. Therefore, a potential loss of energy has to be taken into account when using liquid hydrogen as an energy source.

Compared to other fuels, hydrogen has a higher energy density per mass. However, its low density at ambient temperatures means a lower energy per unit volume. Therefore, the development of storage methods that have the potential for higher energy density is important in order to be able to use hydrogen as an energy source on a larger scale.

SUMMARY

It is an object of the invention to provide hydrogen storage under ambient thermodynamic conditions. Furthermore, it is an object of the invention to facilitate transport of hydrogen, e.g. facilitate low-cost transport and/or facilitate non-explosive transport of hydrogen gas.

These and other objectives of the inventive concept are at least partly met by the invention as defined in the independent claims. Preferred embodiments are set out in the dependent claims.

According to a first aspect, there is provided a device for hydrogen storage, comprising:

a semiconductor substrate,
at least one pillar being arranged on the semiconductor substrate, the at least one pillar comprising a core and a shell, the core of the pillar comprising semiconductor material and the shell of the pillar enclosing the core of the pillar, the shell comprising:

$Mg_3N_2$ and/or
a plurality of GaN particles.

The inventor has realized that hydrogen may be stored in a solid material. Metal or chemical hydrides show high storage capacity but do not satisfy the requirements for the fast kinetics and reversibility. Metal-organic frameworks (MOFs) could be used as storage materials owing to their porosity, fast kinetics and reversibility, but high pressure and cryogenics are necessary for the adsorption process because of the weak adsorption energy of hydrogen molecules, mainly via van der Waals interactions, as described in RSC Adv., 2017, 7, 33953.

The inventor has realized that hydrogen may be stored in $Mg_3N_2$ or GaN particles. Thus, such materials may be seen as hydrogen storage materials. The inventor has further realized that said hydrogen storage materials may be particularly effective in the form of a shell around the core of a pillar. Such an arrangement may enable hydrogen gas to diffuse into the shell and be stored in the shell or at the interface between the core and the shell. There may be several reasons why the device provides efficient hydrogen storage, as described below.

The hydrogen storage material may have a large surface to volume ratio when arranged as a shell around the core of a pillar. A large surface to volume ratio may result in a large storage capacity. Hydrogen storage may be most efficient in the outermost part of the hydrogen storage material, i.e. close to the outer surface of the hydrogen storage material.

The large surface to volume ratio may e.g. facilitate efficient hydrogen diffusion into the hydrogen storage material. The diffusion time may increase, e.g. increase exponentially, with distance into the hydrogen storage material.

Thus, when the hydrogen storage material is arranged as a shell around the core of a pillar, the amount of hydrogen that can be stored may be high and/or the time it takes to load the hydrogen storage material with hydrogen may be short.

Further, the device facilitates electrical control of the hydrogen storage. For example, an electric field may be applied across the shell of the pillar by applying an electrical potential to the core of the pillar. Such electrical control may enable reversible hydrogen storage. An electric field may be utilized to facilitate the binding and releasing of hydrogen. The electric field may, for example, be applied such that binding of hydrogen is facilitated. The electric field may then be reversed such that the release of hydrogen is facilitated.

In view of the above, the device facilitates transport of hydrogen. Hydrogen may be loaded into the shell in a loading step. The device may then be transported, in a transporting step, with the loaded hydrogen. Said transport may be safe as the risk of an explosion may be low when the hydrogen is loaded into the shell. Hydrogen may then be released from the device in a release step.

The loading step may comprise:

placing a device according to the first aspect in a hydrogen atmosphere; and
applying a first electric field across the shell of the pillar by applying an electrical potential to the core of the pillar.

Hydrogen may then be adsorbed and/or absorbed by the shell. The adsorption or absorption may herein be aided or caused by the first electric field.

Hydrogen absorbed by the shell may be held by the shell in a volume of the shell, e.g. homogeneously distributed in the shell.

Hydrogen adsorbed by the shell may be held by the shell on a surface of the shell. Said surface of the shell may be an internal surface of the shell, e.g. a surface between two layers of the shell, such as a surface between two crystalline layers of the shell. Alternatively, said surface of the shell may be an inner surface of the shell, such as the interface surface between the shell and the core of the pillar. Alternatively, said surface of the shell may be an outer surface of the shell.

In the case when hydrogen is adsorbed by the shell, the hydrogen may be attracted to the adsorption surface (e.g. internal surface of the shell and/or inner surface of the shell and/or outer surface of the shell) through London dispersion forces. The London dispersion forces may form from a sheet of electrons formed at the surface of the materials. An electron gas may be formed at the interface between the core of the pillar and the shell of the pillar. The electron gas may be a 2-dimensional electron gas. The inventor has realized that the 2-dimensional electron gas may provide a potential energy well that is able to bind hydrogen. A semiconductor substrate with at least one pillar, according to the inventive concept, facilitates the formation of potential energy wells. The increased surface and the formation of potential energy wells allows for increased storage capacity. The increased storage capacity, according to the inventive concept, allows for greater volumetric efficiency and greater mass storage efficiency. Greater volumetric efficiency and greater mass storage efficiency may lead to that the inventive concept can be efficiently implemented in transportation applications.

After the loading step, the device may be transported in the transporting step. The device may e.g. be transported with no electric field applied across the shell of the pillar. The hydrogen may still be held by the shell without leaking or only leaking slowly. Alternatively, the device may be transported with an electric field applied across the shell of the pillar.

After transportation, hydrogen may be released from the device in the release step. The release step may comprise:
applying a second electric field across the shell of the pillar by applying an electrical potential to the core of the pillar.

The second electric field may have a direction opposite to the first electric field. Hydrogen may then be released by the shell. The release may herein be aided or caused by the second electric field.

The semiconductor substrate may comprise any semiconductor material, e.g. silicon, sapphire, silicon carbide, or GaN. The semiconductor substrate may be a semiconductor substrate suitable for epitaxial growth. It may be particularly useful with a silicon substrate. Silicon substrates are cheap and there are well developed processing methods for silicon in the semiconductor industry. The semiconductor substrate may be a silicon <111> substrate or a silicon <100> substrate. Such substrates may be particularly suitable for epitaxial growth. Herein, <111> and <100> refers to the Miller indices of the substrate surface. The semiconductor substrate may be of a different material than the semiconductor material of the core of the pillar. For example, the semiconductor substrate material may be silicon, sapphire, or silicon carbide and the material of the core of the pillar may be GaN or AlGaN. Any combination of the above-mentioned semiconductor substrate materials and core materials is possible. Alternatively, the semiconductor substrate material and the material of the core of the pillar may be the same material, for example Si. Alternatively, the semiconductor substrate material and the material of the core of the pillar may be any other combination of semiconductor materials.

In the following, the pillar of the device will be discussed. The pillar may be arranged vertically on the substrate. For example, the axis of the pillar may extend in a vertical direction. In this text, a vertical direction refers to a direction normal to the substrate surface. Similarly, a lateral direction refers to a direction parallel with the substrate surface. The device may comprise more than one pillar. For example, the device may comprise a plurality of pillars. Said plurality of pillars may be arranged vertically on the substrate. The plurality of pillars may be an array of pillars. The number of pillars per square mm may be at least 250 000.

The pillar may, in principle, have any thickness. However, a diameter of the pillar may advantageously be below 1 micrometer, preferably below 100 nm. The diameter of the pillar herein includes the shell. Thus, the pillar may be thin. As previously mentioned, the surface area of the hydrogen storage material may be increased by increasing the number of pillars on the semiconductor substrate. An increased semiconductor substrate surface area allows for a greater capacity for storing hydrogen. The thinner the pillars are, the more pillars can be fitted on the same semiconductor substrate, leading to a better surface to volume ratio. It is therefore a realization that a thin pillar allows for more pillars and therefore facilitates an increased capacity for storing hydrogen.

The pillar may, in principle, have any length. However, it may be advantageous with a length above 1 micrometer, such as above 3 micrometers. Such lengths may result in a good surface to volume ratio while being easy to fabricate.

The core of the pillar may comprise a semiconductor material, e.g. silicon, GaN or AlGaN.

The shell of the pillar comprises, as previously mentioned, $Mg_3N_2$ and/or a plurality of GaN particles. The shell encloses the core. For example, the shell may enclose the side walls of the pillar. The shell may encircle the circumference of the pillar.

In the following, a shell comprising $Mg_3N_2$ will be discussed. $Mg_3N_2$ is also known as magnesium nitride. Magnesium nitride may be epitaxially grown both on <100> and <111> crystal orientations, e.g. on <100> or <111> side facets of the core of the pillar. Magnesium nitride may, for example, be sputtered, grown by metalorganic vapor deposition, or grown by plasma-assisted molecular beam epitaxy (MBE), e.g. on silicon substrates, e.g. on a silicon pillar. The $Mg_3N_2$ shell may be doped, e.g. silicon doped. A doped $Mg_3N_2$ shell may be utilized as a reversible hydrogen storage material.

The shell of the pillar may comprise graphitic $Mg_3N_2$. Advantageously, graphitic $Mg_3N_2$ may intercalate the hydrogen to allow hydrogen storage. In graphitic $Mg_3N_2$, the Mg and N atoms form a crystalline structure corresponding to graphite. Graphitic $Mg_3N_2$ may be seen as one or more layers wherein each individual layer has a hexagonal lattice, such as the hexagonal lattice of graphite, and wherein each hexagon of the hexagonal lattice comprises both Mg atoms and N atoms.

The inventor has realized that the formation of a potential energy well facilitates the binding of hydrogen. London dispersion forces in intercalated materials may cause the hydrogen molecules to have a higher binding affinity than that of conventional adsorption by chemisorption or physisorption. Physisorption materials adsorb molecular hydrogen via van der Waals interaction, which is usually below 10 kJ. $mol^{-1}$. Adsorption of hydrogen is favored by London dispersion forces from the electron cloud of the crystal surface. The potential V(r) seen by the hydrogen molecules for storage in graphitic magnesium nitride can be written as

$$V(r) = E(Mg_3N_2 + H_2) - E(Mg_3N_2) - E(H_2).$$

The gas density is $exp\dfrac{-V}{k_B T}$ larger inside the potential energy well than outside of the potential energy well, where V is the depth of the potential energy well, $k_B$ is Boltzmann's constant and T is the temperature as described in RSC Adv., 2017, 7, 33953, which is included by reference herein. The hydrogen storage gravimetric efficiency for graphitic $Mg_3N_2$ may be as high as 15.2 weight percent.

The shell of the pillar may, as an alternative, comprise other crystal structures of $Mg_3N_2$ than graphitic $Mg_3N_2$. For example, the shell of the pillar may comprise $Mg_3N_2$ with a cubic crystal structure, i.e. cubic $Mg_3N_2$. Cubic $Mg_3N_2$ has a lower in-plane lattice constant than silicon.

The shell of the pillar may comprise $Mg_3N_2$ in the form of a thin-film.

A thin-film may be a monolayer of molecules. Alternatively, the thin-film may comprise several layers of molecules. The thin-film may, for example, be sputtered, grown by plasma-assisted MBE, or grown by metalorganic vapor deposition. A thin-film may have a thickness below e.g. 1 micrometer, such as below 100 nm, such as below 10 nm.

It is a realization that the shell may comprise a second thin film, in addition to the $Mg_3N_2$ thin-film. The second thin-film may e.g. comprise gallium nitride. The second-thin film may comprise $Mg_{(x)}Ga_{(1-x)}N_{(y)}$, and/or $Ga_{12}N_{12}$, and/or $Ga_{24}N_{24}$, and/or $MgGa_{11}N_{12}$.

It is further a realization that a thin-film of gallium nitride and/or $Mg_{(x)}Ga_{(1-x)}N_{(y)}$, and/or $Ga_{12}N_{12}$, and/or $Ga_{24}N_{24}$, and/or $MgGa_{11}N_{12}$ may be used in a shell wherein the shell does not comprise $Mg_3N_2$ or GaN particles. Such a shell may still have advantages similar to those discussed in conjunction with the first aspect of the invention.

In the following, a shell comprising GaN particles will be discussed. The term GaN particles may herein be construed as any kind of roughness or perturbation of GaN on a lateral surface of the pillars. The GaN particles may be nanocrystals. A GaN nanocrystal may be seen as a GaN crystalline particle fitting within a sphere with a diameter of 500 nm, or preferably within a sphere with a diameter of 100 nm.

The GaN particles may be formed through epitaxial growth on the core. For example, the GaN particles may be formed through Stranski-Krastanov or a Volmer-Weber growth on the core. Alternatively, the GaN particles may be formed through sputtering of GaN. Sputtering forms, at least under some conditions, small particles (e.g. nanoparticles, or nanocrystals), resulting in a rough surface. Alternatively, the GaN particles may be deposited as aerosols or colloids on the core of the pillar. The GaN particles may have a size below 50 nm, preferably below 5 nm. The GaN particles may be stacked on top of each other. Stacked GaN particles may be separated by grain boundaries and/or by free space. Stacked GaN particles may form a porous shell. In such a porous shell hydrogen may travel deep into the shell through pores between GaN particles and then be trapped in said GaN particles.

The shell may comprise a plurality of GaN particles forming a rough surface of the shell, wherein the rough surface of the shell of the pillar has a root mean square roughness larger than 1 nm. The root mean square roughness is defined as the quadratic average, or root mean square average of profile height deviations from the mean line. Profile height deviations may be measured e.g. by an atomic force microscope.

The plurality of GaN particles with the above mentioned surface roughness may form crystals or cage-like structures. The GaN particle structures may be formed similar to how quantum dots are formed. The binding affinity of the particle formations is high and the structures are arranged to bind hydrogen. The cage-effect of the crystal structures of the GaN particles allows for hydrogen storage capacities similar to the hydrogen storage capacity of a buckyball or fullerene. Thus, one or more hydrogen atoms may be stored in each GaN particle.

It may be particularly advantageous if the rough surface of the shell of the pillar has a root mean square roughness in the range of 1 nm to 10 nm, or in the range of 1 nm to 5 nm. In such a range the hydrogen storage gravimetric efficiency may be particularly high.

A shell comprising GaN particles may have a thickness below e.g. 500 nm, such as below 100 nm, such as below 10 nm.

The shell may have a thickness of less than 10 nm. A shell of a thickness less than 10 nm, which in this text is referred to as a thin shell, may be advantageous for example when placing the semiconductor substrate and the at least one pillar in an electric field. A thin shell may facilitate a large field strength. A thin shell may be cost effective as hydrogen may be stored most effectively in the outermost parts of the shell. Thus, it may be unnecessary to use a thick shell if only the outermost part stores hydrogen.

The semiconductor substrate may have a thickness of 1 mm or more. A semiconductor substrate with a thickness of 1 mm or more may advantageously withstand pressure, for example in the manufacturing process, or when using the device. For example, the semiconductor substrate may be used as part of a wall in a pressurized container.

The shell of the pillar may be epitaxially aligned with the core of the pillar. When the core and the shell are epitaxially aligned they share a crystal periodicity in at least one direction, at least at the interface of the core and the shell. The shell of the pillar may, for example, comprise cubic and/or graphitic $Mg_3N_2$ and/or GaN particles. When the core and shell is epitaxially aligned, there may be a low defect density in the shell and/or a low defect density at the interface between the core and shell. Defects may be e.g. dislocations. Defects may provide deep states which may have an adverse effect on hydrogen storage. Thus, a low defect density may improve hydrogen storage, e.g. improve the hydrogen storage gravimetric efficiency.

The core of the at least one pillar may comprise silicon and/or gallium nitride and/or aluminum nitride and/or aluminum gallium nitride. The crystal orientations of the material of the core of the at least one pillar may for example be <100> or <111>. The core of the pillar may be epitaxially aligned with the semiconductor substrate. The core of the pillar may comprise the same material as the substrate. For example, the core of the pillar may be made of silicon while the substrate is also made of silicon. Such silicon cores may be etched out of the substrate. Alternatively, the core of the pillar may be made of another material than the substrate. For example, the core of the pillar may be made of and/or gallium nitride and/or aluminum nitride and/or aluminum gallium nitride while the substrate is made of silicon.

The at least one pillar may comprise a heterojunction, wherein the heterojunction is configured to form an electron gas. The heterojunction may be configured to form the electron gas by band bending. The electron gas may be formed at the interface between the core of the pillar and the shell of the pillar. The electron gas facilitates the formation of the potential energy well, previously mentioned, such that hydrogen is bound by London dispersion forces. Thus, hydrogen may be bound to the heterojunction. The heterojunction may be formed at the interface between the core and the shell. The heterojunction may be formed at the interface between the core and a $Mg_3N_2$ shell or between the core and one or more GaN particles of the shell.

The device may comprise a flow channel, the flow channel being configured to pass a flow of hydrogen gas, wherein the at least one pillar is arranged in the flow channel, the device further comprising at least two electrodes, the at least two electrodes being configured to apply an electric field between the core of the pillar and the hydrogen gas in the flow channel. The electric field may control the binding and release of hydrogen. For example, the electric field may be used to lower the depth of the potential energy well to release the hydrogen gas, or increase the depth of the same potential energy well for binding hydrogen gas.

According to a second aspect there is provided a method for producing a device for hydrogen storage, the method comprising:

providing a layer of semiconductor material on the semiconductor substrate; and
forming the core of the at least one pillar by etching the layer of semiconductor material; and
providing $Mg_3N_2$ or GaN particles as the shell around the core of the at least one pillar, wherein the shell is provided by sputtering or metalorganic vapor deposition.

The layer of semiconductor material may be provided by epitaxial growth, e.g. by metalorganic vapor deposition, or by sputtering.

The method may also include that the core of the pillar is lattice mismatched to GaN material and GaN particles are provided as the shell around the core of the at least one pillar by epitaxial growth in a Stranski-Krastanov or a Volmer-Weber growth mode. Thus, the GaN particles may be formed by strain driven self-assembly. Thus, the GaN particles may be quantum dots. Self-assembled GaN particles may provide a high particle density and/or small particles and/or a suitable surface roughness. This may be beneficial for providing efficient hydrogen storage.

BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.

Fig. 1A illustrates a cross section of a device in a side-view
Fig. 1B illustrates a cross section of a device in a top-view
Fig. 2 illustrates a cross section of a device in a side-view
Fig. 3 illustrates a device in perspective view
Fig. 4 illustrates a layer of graphitic $Mg_3N_2$
Fig. 5 illustrates a cross section of a device in a side-view
Fig. 6 illustrates a cross section of a device in a side-view
Fig. 7 illustrates a cross section of a device in a side-view
Fig. 8 illustrates a cross section of a device in a side-view
Fig. 9 is a flow chart of a method

DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

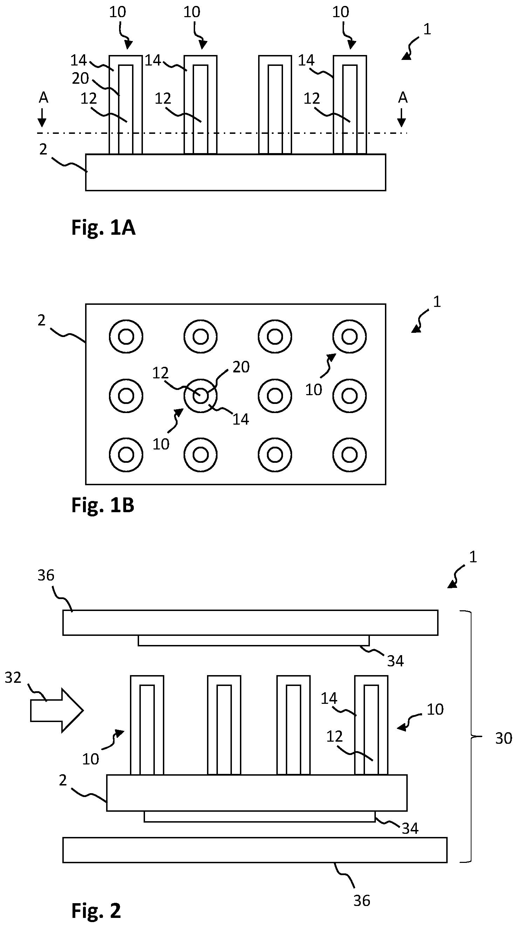

Fig. 1 A and B illustrate cross sections of a device 1. Fig. 1A is a side view of a cross section of the device 1. Fig. 1B is a top view of a cross section of the same device 1, wherein the cross section is a cross section along line A-A in Fig. 1A. The illustrated device 1 comprises a semiconductor substrate 2 on which a plurality of pillars 10 are arranged.

Each pillar 10 comprises a core 12 and a shell 14. The core 12 and shell 14 may have a circular cross section, as illustrated in Fig. 1B. Alternatively, the core 12 and shell 14 may have a cross section of another shape, e.g. hexagonal. The shell 14 encloses the core, e.g. by extending over the lateral surfaces of the core 12. The shell 14 may additionally, as illustrated, extend over a top surface of the core 12. The $Mg_3N_2$ and/or the GaN particles 16 of the shell 14 may cover lateral surfaces of the core 12. For example, the $Mg_3N_2$ and/or the GaN particles 16 of the shell 14 may cover lateral surfaces of the core 12 fully or partially. The $Mg_3N_2$ and/or the GaN particles 16 of the shell 14 may cover at least 30%, such as at least 70%, of the surface area of the lateral surfaces of the core 12.

The core 12 and shell 14 may comprise different materials. Thus, the interface between the core 12 and shell 14 may form a heterojunction 20. Such a heterojunction is illustrated in Fig. 1 A and B. Said heterojunction 20 may be configured to form an electron gas. For example, the core 12 may be made of AlGaN while the shell 14 is made of GaN, or vice versa. At the interface between such a core 12 and shell 14 an electron gas may form. Said electron gas may be seen as a two-dimensional electron gas wrapped around the core 12. Similarly, the heterojunction 20 may be formed at the interface between the core 12 and a $Mg_3N_2$ shell or between the core and one or more GaN particles of the shell 14.

Fig. 2 illustrates a cross section of a device 1 comprising a flow channel 30, the flow channel 30 being configured to pass a flow 32 of hydrogen gas, wherein the at least one pillar 10 is arranged in the flow channel 30. The device 1 further comprises two electrodes 34 configured to apply an electric field between the core 12 of the pillar 10 and the hydrogen gas in the flow channel 30.

The flow channel 30 may be any form of pipe, box, or container through which a hydrogen flow can pass. The flow channel 30 may comprise walls 36 configured to prevent hydrogen gas from escaping. One electrode 34 may be arranged on the substrate 2, e.g. on the back side of the substrate 2. Another electrode 34 may be arranged at a different location of the flow channel 30, e.g. on a wall 36 of the flow channel 30. By applying different electric potentials to the two electrodes 34, an electric field may be applied across the shell 14 of each pillar 10. The substrate 2 and/or the core 12 may herein be doped such that a large part of the potential drop falls over the shell 14, whereby the electric field in the shell 14 becomes large.

The flow channel 30 may be configured such that the substrate 2 with the pillars 10 may be removed. Thus, the shells 14 of the pillars 10 may be loaded with hydrogen in the flow channel 30, e.g. in the above mentioned loading step, by applying a first electric field. The substrate 2 with the pillars 10 may then be removed and transported elsewhere. The hydrogen stored in the shells 14 of the pillars 10 may then be released, e.g. in the above mentioned release step. For example, the substrate 2 with pillars 10 may be placed in another flow channel 30 and a second electric field may be applied across the shells 14 of the pillars 10. The second electric field may have a direction opposite to the first electric field. As an alternative to removing the substrate 2 with the pillars 10, they may stay in the same flow channel 30 for both the loading and release step.

The substrate 2 may have a thickness of 1 mm or more. This may be advantageous if there is a pressure difference between the front side and the back side of the substrate 2. For example, if the substrate 2 forms part of a wall 36 of the flow channel 30.

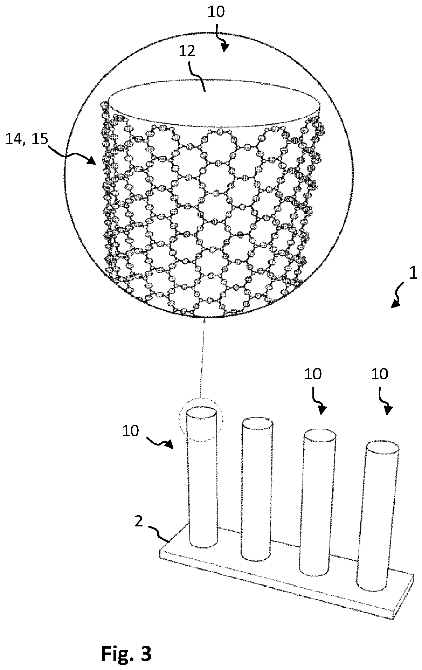

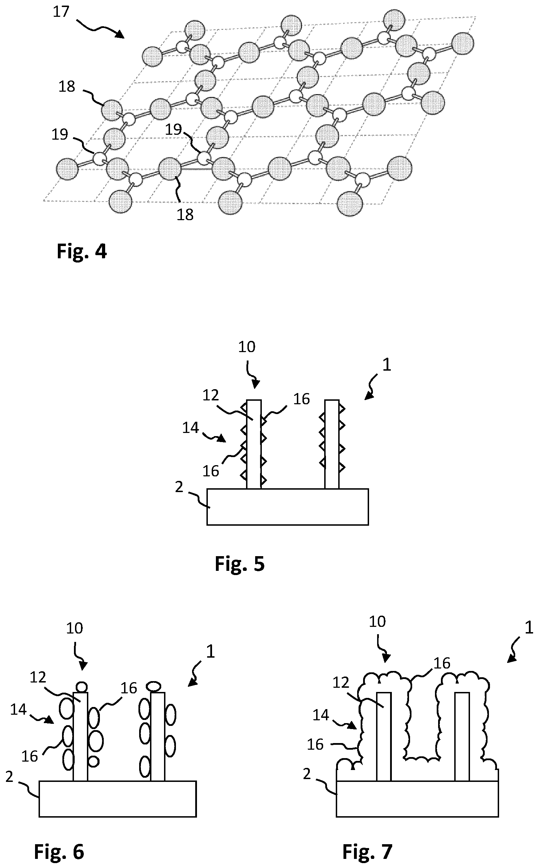

Fig. 3 illustrates a device 1 in perspective view. The shell 14 of the pillars 10 of the illustrated device 1 comprises graphitic $Mg_3N_2$. As seen in the enlarged portion of the figure, the illustrated pillar 10 has a shell 14 comprising a single layer 17 of graphitic $Mg_3N_2$ which is wrapped around the core 12 of the pillar 10. As an alternative, the pillar 10 may have a shell 14 comprising multi-layer graphitic $Mg_3N_2$. Each individual layer 17 of graphitic $Mg_3N_2$ has a hexagonal lattice, similar to the hexagonal lattice of graphite. A layer 17 of graphitic $Mg_3N_2$ is illustrated in Fig. 4, wherein magnesium atoms 18 are illustrated with a dotted texture and nitrogen atoms 19 are illustrated white. The dashed square lattice is a guide to the eye.

As an alternative to the shell 14 comprising graphitic $Mg_3N_2$, the shell may comprise other forms of $Mg_3N_2$, e.g. cubic $Mg_3N_2$.

Figs 5-7 illustrates that the shell 14 may comprise GaN particles 16. Figs 5-7 illustrates cross sections of devices 1 seen in side-view. The GaN particles 16 may be scattered on the lateral surfaces of the core 12 and not cover the full surface area of the lateral surfaces of the core 12, as seen in Figs 5-6. The GaN particles 16 may e.g. cover at least 30% or at least 70% of the surface area of the lateral surfaces of the core 12. Alternatively, the GaN particles 16 may cover the full surface area of the lateral surfaces of the core 12, as seen in Fig. 7.

The GaN particles 16 may be grown epitaxially on the lateral surfaces of the core 12. The GaN particles 16 may be grown epitaxially in the Stranski-Krastanov or the Volmer-Weber growth mode. Such GaN particles 16 may be lattice mismatched to the core 12 and form by strain driven self-assembly. Such GaN particles 16 may have the shape of pyramids, truncated pyramids, or domes. Fig. 5 illustrates how GaN particles 16 with a pyramidal shape may look in cross section.

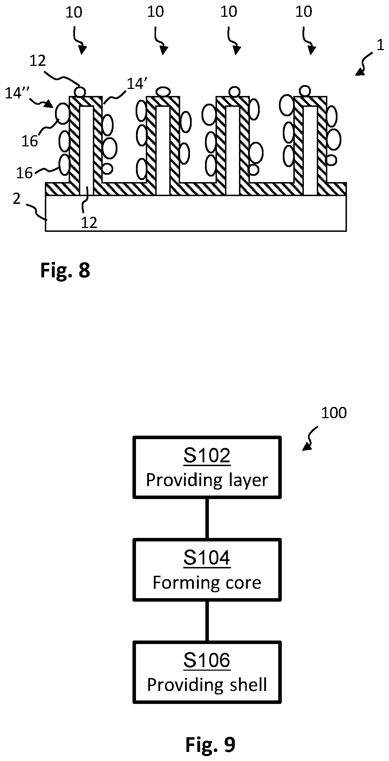

Fig. 8 illustrates that multiple shells 14 may be used. Fig. 8 a cross section of a device 1 in a side-view. The illustrated device 1 comprises a first 14' and a second 14" shell. The first shell 14' may be a $Mg_3N_2$ shell. The second shell 14" may be a shell comprising GaN particles 16.

Fig. 9 shows a flow chart of a method 100 for producing a device 1 according to the first aspect. According to the method 100, a layer of semiconductor material is provided S102 on the semiconductor substrate 2. The layer of semiconductor material may be provided S102 by epitaxial growth. The core 12 of the at least one pillar 10 is then formed S104 by plasma etching the layer of semiconductor material with a chlorine plasma. For example, the layer of semiconductor material may be patterned by lithographic means, e.g. by nanoimprint lithography or photolithography, and etched to form columns which later will become the cores 12 of the pillars 10. Once the core 12 of the at least one pillar 10 is formed S104, $Mg_3N_2$ or GaN particles 16 are provided S106 as the shell 14 around the core 12 of the at least one pillar 10. This is done by sputtering or metalorganic vapor deposition.

The core 12 of the pillar 10 may be lattice mismatched to GaN material. For example, the core 12 of the pillar 10 may comprise another material than GaN. GaN particles 16 may then be provided S106 as the shell 14 around the core 12 of the at least one pillar 10 by epitaxial growth in a Stranski-Krastanov or a Volmer-Weber growth mode. For example, when growing a few monolayers, e.g. 8-10 monolayers, of shell material which is lattice mismatched to the core 12, said monolayers may rearrange in a self-assembly process to form quantum dots. Said quantum dots may be seen as GaN particles 16 forming a rough surface.

Thus, the quantum dots of the shell 14 may be self-assembled quantum dots. The quantum dots may e.g. be Stranski-Krastanov quantum dots. Thus, the shell 14 may, in addition to the quantum dots, comprise a wetting layer. Alternatively, the quantum dots of the shell 14 may be Volmer-Weber quantum dots. Self-assembled quantum dots may provide a high quantum dot density and/or small quantum dots. This may be beneficial for enabling efficient hydrogen storage.

Under some conditions the GaN particles 16 are provided by means other than Stranski-Krastanov or a Volmer-Weber growth. For example, GaN particles 16 may be provided as small droplets sputtered onto the lateral sides of the etched columns. As an alternative, GaN particles 16 may be provided as aerosols or colloids deposited onto the lateral sides of the etched columns.

In the above the inventive concept has mainly been described with reference to a limited number of examples. However, as is readily appreciated by a person skilled in the art, other examples than the ones disclosed above are equally possible within the scope of the inventive concept, as defined by the appended claims.

**Claims**

1. A device (1) for hydrogen storage, comprising:

   a semiconductor substrate (2);
   at least one pillar (10) being arranged on the semiconductor substrate (2), the at least one pillar (10) comprising a core (12) and a shell (14), the core (12) of the pillar (10) comprising semiconductor material and the shell (14) of the pillar (10) enclosing the core (12) of the pillar (10), the shell (14) comprising:

   $Mg_3N_2$; and/or
   a plurality of GaN particles (16).

2. The device (1) according to claim 1, wherein the shell comprises graphitic $Mg_3N_2$.

3. The device (1) according to claim 1 or 2, wherein the shell (14) of the pillar (10) comprises $Mg_3N_2$ in the form of a thin-film.

4. The device (1) according to any one of the preceding claims, wherein the shell comprises a plurality of GaN particles (16) forming a rough surface of the shell (14), wherein the rough surface of the shell (14) of the pillar (10) has a root mean square roughness larger than 1 nm.

5. The device (1) according to any one of the preceding claims, wherein the shell (14) has a thickness of less than 10 nm.

6. The device (1) according to any one of the preceding claims, wherein the semiconductor substrate (2) has a thickness of 1 mm or more.

7. The device (1) according to any one of the preceding claims, wherein the shell (14) of the pillar (10) is epitaxially aligned with the core (12) of the pillar (10).

8. The device (1) according to any one of the preceding claims, wherein the core (12) of the at least one pillar (10) comprises gallium nitride and/or aluminum nitride and/or aluminum gallium nitride.

9. The device (1) according to any one of the preceding claims, wherein the at least one pillar (10) comprises a heterojunction (20), wherein the heterojunction (20) is configured to form an electron gas.

10. The device (1) according to any one of the preceding claims, wherein the device (1) comprises a flow channel (30), the flow channel (30) being configured to pass a flow (32) of hydrogen gas, wherein the at least one pillar is arranged in the flow channel (30), the device (1) further comprising at least two electrodes (34), the at least two electrodes (34) being configured to apply an electric field between the core (12) of the pillar (10) and the hydrogen gas in the flow channel (30).

11. A method (100) for producing a device according to any one of claims 1-10, the method (100) comprising:

   providing (S102) a layer of semiconductor material on the semiconductor substrate (2); and
   forming (S104) the core (12) of the at least one pillar (10) by etching the layer of semiconductor material; and

providing (S106) $Mg_3N_2$ or GaN particles as the shell (14) around the core (12) of the at least one pillar (10), wherein the shell (14) is provided by sputtering or metalorganic vapor deposition.

12. The method (100) according to claim 11, wherein the core (12) of the pillar (10) is lattice mismatched to GaN material and GaN particles are provided (S106) as the shell (14) around the core (12) of the at least one pillar (10) by epitaxial growth in a Stranski-Krastanov or a Volmer-Weber growth mode.

**Fig. 1A**

**Fig. 1B**

**Fig. 2**

**Fig. 3**

17

18

19        19

18

**Fig. 4**

10

12        16

14

16

2

1

**Fig. 5**

10

12        16

14

16

2

1

**Fig. 6**

10        16

12

14

16

2

1

**Fig. 7**

10    10    10    10

12        14'                    1

14''

16

16

16

2

12

**Fig. 8**

100

S102
Providing layer

S104
Forming core

S106
Providing shell

**Fig. 9**

Europäisches
Patentamt

European
Patent Office

Office européen
des brevets

# EUROPEAN SEARCH REPORT

Application Number

EP 22 21 4665

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 082 037 A1 (ALEDIA [FR]) 2 November 2022 (2022-11-02) | 1-3,5,6, 9 | INV. C01B3/00 |
| A | * paragraphs [0013], [0066], [0091] – paragraph [0096]; figure 9 * | 10 | |
| X | US 2006/060866 A1 (TEZEN YUTA [JP]) 23 March 2006 (2006-03-23) | 1-5,7-9, 11,12 | |
| A | * paragraphs [0023], [0035], [0067], [0082] – paragraph [0084]; figure 2C * | 10 | |
| A | NABI GHULAM: "Photoluminescence and hydrogen storage properties of gallium nitride hexagonal micro-bricks – ScienceDirect", MATERIALS LETTERS, vol. 79, 15 July 2012 (2012-07-15), pages 212-215, XP093048468, * paragraph [03.2]; figure 3 * | 1-12 | |
| A | MYERS S M ET AL: "Diffusion, release, and uptake of hydrogen in magnesium-doped gallium nitride: Theory and experiment", JOURNAL OF APPLIED PHYSICS, AMERICAN INSTITUTE OF PHYSICS, 2 HUNTINGTON QUADRANGLE, MELVILLE, NY 11747, vol. 89, no. 6, 15 March 2001 (2001-03-15), pages 3195-3202, XP012053108, ISSN: 0021-8979, DOI: 10.1063/1.1347410 * paragraph [0III]; figures 2,3 * | 1-12 | |

TECHNICAL FIELDS SEARCHED (IPC)

C01B

The present search report has been drawn up for all claims

| Place of search | Date of completion of the search | Examiner |
|---|---|---|
| Munich | 24 May 2023 | Cristescu, Ioana |

EPO FORM 1503 03.82 (P04C01)

## ANNEX TO THE EUROPEAN SEARCH REPORT
## ON EUROPEAN PATENT APPLICATION NO.

EP 22 21 4665

This annex lists the patent family members relating to the patent documents cited in the above-mentioned European search report.
The members are as contained in the European Patent Office EDP file on
The European Patent Office is in no way liable for these particulars which are merely given for the purpose of information.

24-05-2023

| Patent document cited in search report | | Publication date | Patent family member(s) | | Publication date |
|---|---|---|---|---|---|
| EP 4082037 | A1 | 02-11-2022 | CN | 114868241 A | 05-08-2022 |
| | | | EP | 4082037 A1 | 02-11-2022 |
| | | | FR | 3105748 A1 | 02-07-2021 |
| | | | JP | 2023508443 A | 02-03-2023 |
| | | | KR | 20220119630 A | 30-08-2022 |
| | | | US | 2023035764 A1 | 02-02-2023 |
| | | | WO | 2021130136 A1 | 01-07-2021 |
| US 2006060866 | A1 | 23-03-2006 | AU | 3416901 A | 24-09-2001 |
| | | | CN | 1429402 A | 09-07-2003 |
| | | | CN | 1624876 A | 08-06-2005 |
| | | | EP | 1265272 A1 | 11-12-2002 |
| | | | JP | 2001267242 A | 28-09-2001 |
| | | | KR | 20020084193 A | 04-11-2002 |
| | | | KR | 20060019614 A | 03-03-2006 |
| | | | US | 2003162340 A1 | 28-08-2003 |
| | | | US | 2006060866 A1 | 23-03-2006 |
| | | | WO | 0169662 A1 | 20-09-2001 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• *RSC Adv.,* 2017, vol. 7, 33953